# EUROPEAN PATENT APPLICATION

(11) **EP 2 677 665 A1**
(43) Date of publication of application: **25.12.2013**
(21) Application number: 13150484.7
(22) Date of filing: 08.01.2013
(51) Int. Cl.: H04B 1/28, H03D 7/16, H03D 7/18, H04B 15/06, H04B 1/00, H04B 1/10

(54) **Superheterodyne radio-frequency receiver device of wireless communication system**

(30) Priority: 18.06.2012 TW 101121720
(71) Applicant: Wistron Neweb Corporation, Hsinchu 308 (TW)
(72) Inventor: Ko, Chih-Chang, 308 Hsinchu (TW); Wang, Che-Ming, 308 Hsinchu (TW)
(74) Representative: Becker Kurig Straus

(57) **Abstract**

A radio-frequency (RF hereafter) receiver (30) device for a wireless communication system includes a first filter (302) for filtering out a first RF signal (RF_1) within a first frequency band (BD_1), a first frequency converter (304) for using a first oscillating signal to convert the first RF signal of the first frequency band (BD_1) to generate a second RF signal (RF_2), a second filter (306) for filtering out a second RF signal (RF_2) within a second frequency band (BD_2), a second frequency converter (308) for using a second oscillating signal (LO_2) to convert the second RF signal (RF_2) of the second frequency band (BD_2) to generate a third RF signal (RF_3), a third filter (310) for filtering out a third RF signal (RF_3) within a third frequency band (BD_3), and a controller (312) for controlling the first frequency converter (304) and the second frequency converter (308).

## Description

### Field of the Invention

The present invention relates to a radio-frequency (RF) receiver device for a wireless communication system, and more particularly, to an RF receiver device capable of avoiding an oscillating signal or harmonic signals thereof being in signal regions and interfering with the signal quality and characteristics.

### Background of the Invention

In the prior art, a superheterodyne receiver is one of the most widely used wireless communication receivers, which facilitates carrier frequency adjustment, filtering, and amplifying. Therefore, the superheterodyne receiver is applied not only in wireless network but also in other applications such as satellite, broadcast, mobile communications, and so on. For example, an optical low noise block (LNB) system is widely employed in satellite communication technology. Different from a traditional LNB system, an optical LNB system can be used in a multi-user system such as a satellite master antenna television (SMATV), a high-end and long-distance transmission, and so on. In general, an optical LNB system includes a front-end optical LNB system and a multi-dwelling unit (MDU). The front-end optical LNB system converts satellite signals into electrical signals with frequencies ranging between 950MHz and 5450MHz, transforms the electrical signals into optical signals, and transmits the optical signals to 32 optical nodes via optical fibers. Each optical node uses an MDU to transform the optical signals to electrical signals, and down-convert the electrical signal into 950MHz-2150MHz, which can be read by a setup box (STB). In each optical node, the structure of the MDU conforms to a superheterodyne receiver.

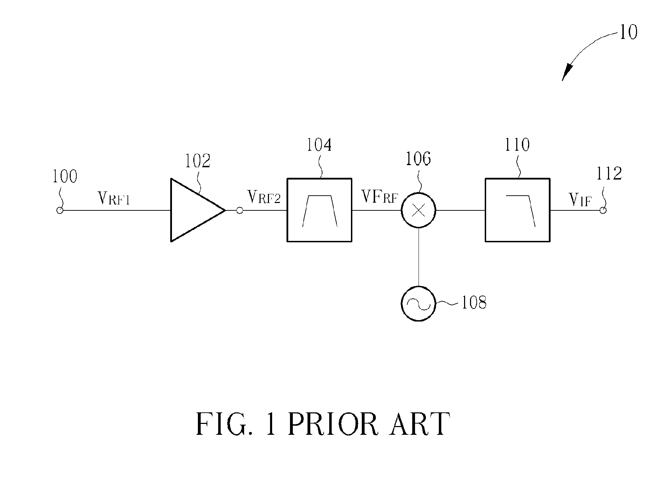

Please refer to Fig. 1, which is a schematic diagram of a superheterodyne receiver 10 in the prior art. The superheterodyne receiver 10 includes a receiver 100, a low-noise amplifier 102, an image reject filter 104, a mixer 106, a local oscillator 108, a low-pass filter 110, and an output terminal 112. The operating principle of the superheterodyne receiver 10 is well-known in the industry and is narrated as below. An RF signal V_{RF1}, received by the receiver 100, is amplified to be an RF signal V_{RF2} via the low-noise amplifier 102. The image reject filter 104 filters out an image frequency signal within the RF signal V_{RF2} to generate an RF filtering signal VF_{RF}. The mixer 106 mixes the RF filtering signal VF_{RF} with a local oscillating signal LO generated by the local oscillator 108 to down-convert the RF filtering signal VF_{RF} to an intermediate-frequency (IF) band. Finally, the low-pass filter 110 filters the RF filtering signal VF_{RF} and the output terminal 112 outputs a corresponding IF signal V_{IF} to the rear-end circuit, so as to perform demodulation, decoding, de-multiplexing, etc., and obtain messages therein.

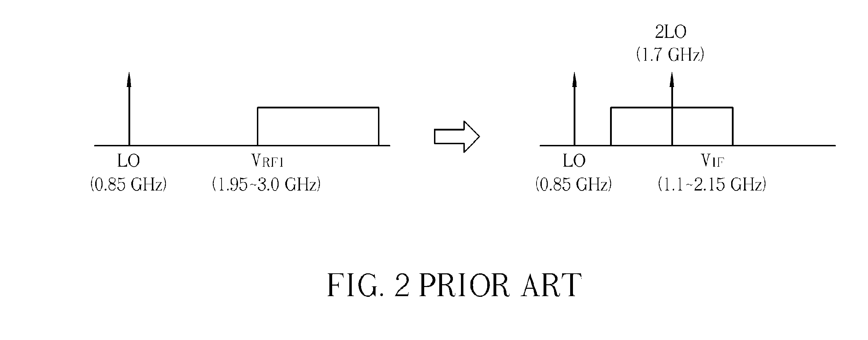

In general, except for the environment noise or interference, the root cause affecting the receiving efficiency of the superheterodyne receiver 10 is noise or interference generated by the relevant elements. If a double frequency of the local oscillating signal LO is within a signal region of the IF signal V_{IF} due to the operating frequency band required by the rear-end circuit, after the mixer 106 performs mixing, the double frequency signal 2LO may severely interfere with the signal quality and characteristics of the IF signal V_{IF}. For example, if the frequency of the RF signal V_{RF1} ranges between 1.95GHz and 3GHz, and the frequency of the IF signal V_{IF} required by the rear-end circuit ranges between 1.1 GHz and 2.15GHz, the frequency of the required local oscillating signal LO should be 0.85GHz. In such a situation, after the mixer 106 operates, the double frequency signal 2LO of the local oscillating signal LO is within the signal region of the IF signal V_{IF}, as shown in Fig. 2, and further interferes with the signal quality and characteristics of the IF signal V_{IF}.

In such a situation, avoiding the double frequency of the local oscillating signal being within the signal region of the output signal and further interfering with the signal quality and characteristics becomes one of the goals the industry aims for.

### Summary of the Invention

This in mind, the application aims at providing a radio-frequency, abbreviated in RF hereafter, receiver device in a wireless communication system in order to solve the abovementioned problems.

This is achieved by an RF receiver device according to claim 1. The dependent claims pertain to corresponding further developments and improvements.

As will be seen more clearly from the detailed description following below, the claimed RF receiver device includes an RF receiver device for a wireless communication system, including a receiver for receiving a first RF signal; a first filter, coupled to the receiver, for filtering and obtaining a first RF signal within a first frequency band; a first frequency converter, coupled to the first filter, for using a first oscillating signal to convert the first RF signal of the first frequency band to generate a second RF signal; a second filter, coupled to the first frequency converter, for filtering and obtaining a second RF signal within a second frequency band; a second frequency converter, coupled to the second filter, for using a second oscillating signal to convert the second RF signal of the second frequency band to generate a third RF signal; a third filter, coupled to the second frequency converter, for filtering and obtaining a third RF signal within a third frequency band; and a controller, for controlling the first frequency converter and the second frequency converter.

### Brief Description of the Drawings

Fig. 1 is a schematic diagram of a superheterodyne receiver according to the prior art.
Fig. 2 is a schematic diagram of the superheterodyne receiver shown in Fig. 1 when interference occurs.
Fig. 3 is a schematic diagram of a radio-frequency receiver device according to an embodiment of the present invention.
Fig. 4 is a schematic diagram of a first frequency converter shown in Fig. 3.
Fig. 5 is a schematic diagram of a frequency-band relationship shown in Fig. 3.
Fig. 6 is a schematic diagram of a multi dwelling unit according to an embodiment of the present invention.

### Detailed Description

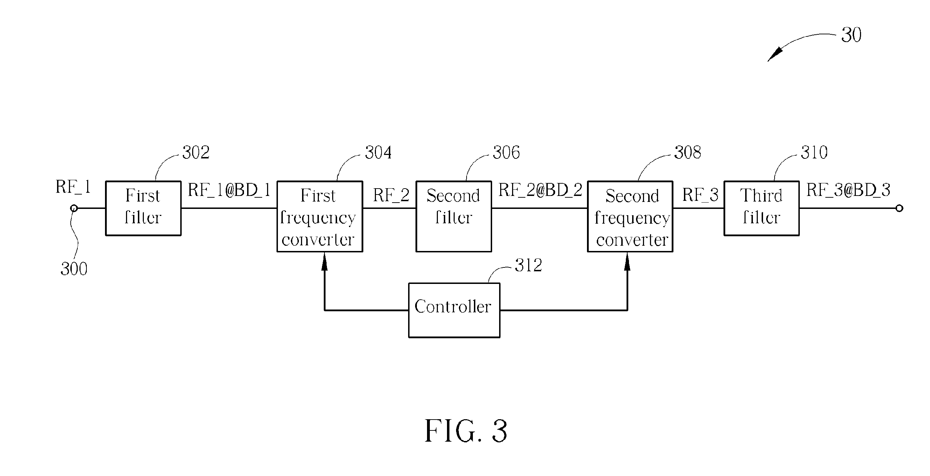

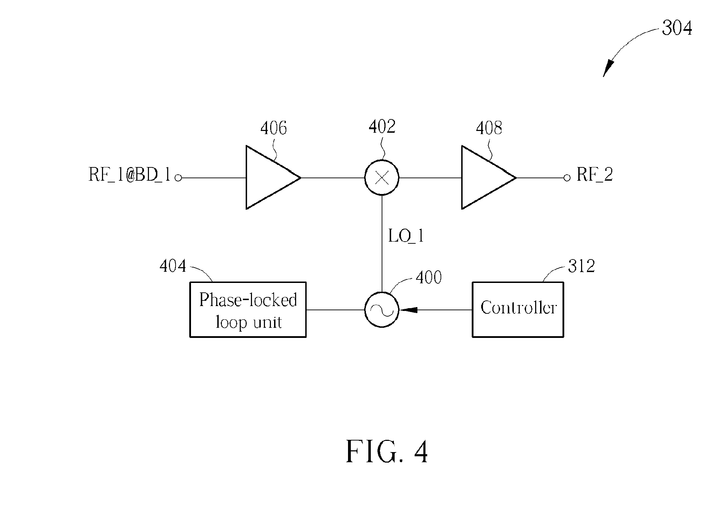

Please refer to Fig. 3, which is a schematic diagram of a radio-frequency (RF) receiver device 30 according to an embodiment of the present invention. The RF receiver device 30 may be used in wireless communication systems of satellite, broadcast, mobile communication, fiber optic communication, etc., for example, to implement a multi dwelling unit (MDU) employed in an optical low noise block (LNB) system. The RF receiver device 30 includes a receiver 300, a first filter 302, a first frequency converter 304, a second filter 306, a second frequency converter 308, a third filter 310, and a controller 312. The receiver 300 receives a first RF signal RF_1, which can be, but not limited to, an RF signal received by an antenna or a photo diode, or an output of a power divider. The first filter 302 may be a high-pass filter, for filtering and obtaining the first RF signal RF_1 within a first band BD_1. Therefore, for simplicity and clarity, "RF_1 @BD_1" is represented as the first RF signal RF_1 within a first band BD_1 in Fig. 3. The first frequency converter 304 is coupled to the first filter 302, for using a first oscillating signal LO_1 (which is not shown in Fig. 3 but further described in Fig. 4) to convert the first RF signal RF_1 of the first frequency band BD_1 to generate a second RF signal RF_2. The second filter 306 is coupled to the first frequency converter 304, which may be a low-pass filter, for filtering and obtaining the second RF signal RF_2 within the second band BD_2. By the same token, "RF_2@BD_2" is represented as the second RF signal RF_2 within the second band BD_2. The second frequency converter 308 is coupled to the second filter 306, for using a second oscillating signal LO_2 (which is not shown in Fig. 3 but further described in Fig. 4) to convert the second RF signal RF_2 of the second frequency band BD_2 to generate a third RF signal RF_3. The third filter 310 may be a low-pass filter, for filtering and obtaining the third RF signal within a third frequency band, which is resented by "RF_3@BD_3". The first frequency converter 304 and the second frequency converter 308 are both controlled by the controller 312 to adjust the frequencies of the first oscillating signal LO_1 and the second oscillating signal LO_2, so that the first oscillating signal LO_1 and harmonic signals thereof, and the second oscillating signal LO_2 and harmonic signals thereof, are not within the third frequency band BD_3.

In brief, in order to avoid the double frequency signal of the oscillating signal being within the frequency band of the RF signal after frequency mixing and further interfering with the signal quality and characteristics, the RF receiver device 30 uses the two-stage converting operation (i.e. the first frequency converter 304 and the second frequency converter 308) and properly sets the frequencies of the first and second oscillating signals LO_1 and LO_2 of the first and second frequency converters 304 and 308 via the controller 312, to keep the first oscillating signal LO_1 and harmonic signals, and the second oscillating signal LO_2 and harmonic signals, out of the third frequency band BD_3. Accordingly, the RF receiver device 30 can avoid the first oscillating signal LO_1 or the second oscillating signal LO_2 being in the signal region and further interfering with the signal quality and characteristics, and therefore make sure that the subsequent operations of demodulating, decoding, de-multiplexing, etc., can operate normally.

Note that, the first frequency converter 304 and the second frequency converter 308 perform down-converting processes and are preferably implemented by single chips, but this is not a limitation herein. Moreover, in order to reduce the complexity, the first frequency converter 304 and the second frequency converter 308 can use the same structure, but neither is this a limitation. Therefore, for simplicity, the first frequency converter 304 is taken as a representation. Please continue to refer to Fig. 4, which is a schematic diagram of the first frequency converter 304 shown in Fig. 3. The first frequency converter 304 includes an oscillating signal generator 400, a mixer 402, a phase-locked loop unit 404, and amplifiers 406 and 408. The amplifiers 406 and 408 are respectively a low-noise amplifier and an IF amplifier, for enhancing the signal energy. According to system requirements, the amplifiers 406 and 408 may be removed in some embodiments. The oscillating signal generator 400 is controlled by the controller 312 to generate the first oscillating signal LO_1. The phase-locked loop unit 404 stabilizes the first oscillating signal LO_1 generated by the oscillating signal generator 400. Therefore, if the system tolerance is larger, the phase-locked loop unit 404 can also be removed. Besides, the mixer 402 mixes the (amplified) first RF signal RF_1 within the first frequency band BD_1 generated by the amplifier 406 with the first oscillating signal LO_1 generated by the oscillating signal generator 400. The basic concept of mixing is to multiply two signals in time domain, i.e. perform convolution operation in frequency domain, to achieve the up-converting or down-converting process, and this operating method is well-known in the art. The second RF signal RF_2 generated by the first frequency converter 340 can be down-converted via the second filter 306.

The structure of the second frequency converter 308 is the same as that of the first frequency converter 304, except that the second frequency converter 308 is controlled by the controller 312 to generate the second oscillating signal LO_2.

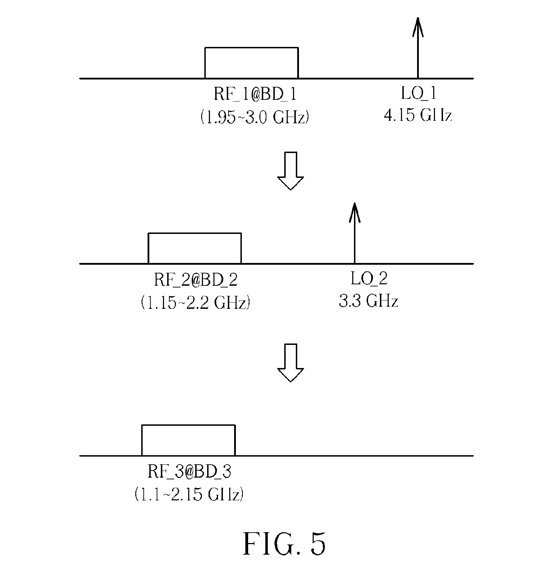

Note that, in addition to the two-stage converting operation, it is important that the embodiment of the present invention properly sets the frequencies of the first oscillating signal LO_1 and the second oscillating signal LO_2. For example, if the frequency of the first RF signal RF_1, i.e. the first frequency band BD_1, substantially ranges between 1.95GHz and 3GHz, and the required signal region, i.e. the third frequency band BD_3, substantially ranges between 1.1 GHz and 2.15GHz, the frequency of the first oscillating signal LO_1 may be set to be 4.15GHz and the frequency of the second oscillating signal LO_2 may be set to be 3.3GHz. As a result, the second frequency band BD_2 substantially ranges between 1.15GHz and 2.2GHz and the corresponding frequency-band relationship is shown in Fig. 5. In such a situation, the frequency or harmonics of the first oscillating signal LO_1, and the frequency or harmonics of the second oscillating signal LO_2, are out of the third frequency band BD_3, so as to avoid the first oscillating signal LO_1 and the second oscillating signal LO_2 interfering with the signal quality and characteristics of the third RF signal RF_3.

As can be seen, using the two-stage converting operation, the present invention can keep the first oscillating signal LO_1 and the second oscillating signal LO_2 out of the third frequency band BD_3, so as to avoid interfering with the signal quality and characteristics of the third RF signal RF_3.

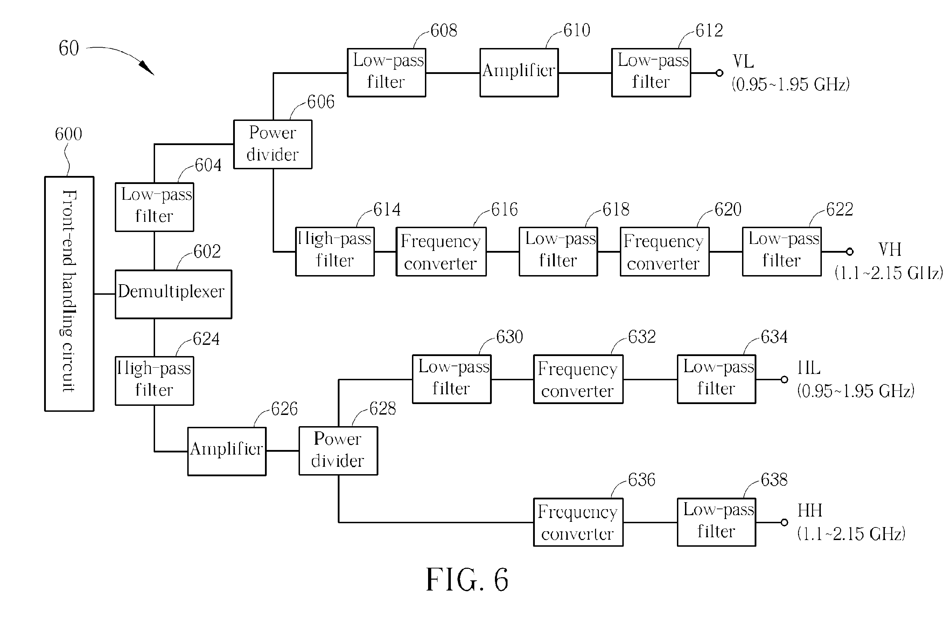

In addition, as to MDU applications, the single-chip structure of the first frequency converter 304 and the second frequency converter 308 can be used for increasing isolation. For example, please refer to Fig. 6, which is a schematic diagram of an MDU 60 according to an embodiment of the present invention. The MDU 60 includes a front-end handling circuit 600, low-pass filters 604, 608, 612, 618, 622, 630, 634, 638, power dividers 606 and 628, high-pass filters 614 and 624, amplifiers 610 and 626, and frequency converters 616, 620, 632, 636. The MDU 60 receives optical signals (with frequencies between 0.95 and 5.45GHz) generated by a front-end optical LNB system, transforms the optical signals back to electrical signals, and down-converts the electrical signals to signals VL (with frequencies between 0.95 GHz and 1.95GHz), VH (with frequencies between 1.1 GHz and 2.15GHz), HL (with frequencies between 0.95GHz and 1.95GHz), and HH (with frequencies between 1.1 GHz and 2.15GHz). Moreover, the circuitry for generating the signals VH is the same as the RF receiver device 30 shown in Fig. 3. In other words, oscillating signals used by the frequency converters 616 and 620 are out of the signal region of the signals VH, and the signal quality and characteristics are assured. Besides, as shown in Fig. 6, the frequency converters 616, 620, 632, 636 are independent devices, so that interference caused by the mixing processes of the oscillating signals required in the down-converting process is reduced.

Note that, the controller for controlling the oscillating signals of the frequency converters 616, 620, 632, and 636 is neglected in Fig. 6, which can be an independent micro-controller or implemented by control commands compiled in the frequency converters 616, 620, 632, and 636 by firmware.

In the superheterodyne receiver of the prior art, when the double frequency of the oscillating signal is in the signal region of the output signal, after the mixer operates, the double-frequency oscillating signal may severely interfere with the signal quality and characteristics of the output signal. In comparison, the present invention uses the two-stage converting operation and properly sets the frequencies of the required oscillating signals, to keep the oscillating signal and harmonic signals thereof out of the frequency band of the output signal. As a result, the present invention can avoid the oscillating signal or its harmonic signals being in the signal region and further interfering with the signal quality and characteristics, so as to ensure the subsequent operations of demodulating, decoding, de-multiplexing, etc., can be normally performed.

## Claims

1. A radio-frequency (RF hereafter) receiver device (30) for a wireless communication system, **characterized by**:
a receiver (300), for receiving a first RF signal (RF_1);
a first filter (302), coupled to the receiver (300), for filtering and obtaining a first RF signal (RF_1) within a first frequency band (BD_1);
a first frequency converter (304), coupled to the first filter (302), for using a first oscillating signal (LO_1) to convert the first RF signal (RF_1) of the first frequency band (BD_1) to generate a second RF signal (RF_2);
a second filter (306), coupled to the first frequency converter (304), for filtering and obtaining a second RF signal (RF_2) within a second frequency band (BD_2);
a second frequency converter (308), coupled to the second filter (306), for using a second oscillating signal (LO_2) to convert the second RF signal (RF_2) of the second frequency band (BD_2) to generate a third RF signal (RF_3);
a third filter (310), coupled to the second frequency converter (308), for filtering and obtaining a third RF signal (RF_3) within a third frequency band (BD_3); and
a controller (312), for controlling the first frequency converter (304) and the second frequency converter (308).

2. The RF receiver device of claim 1, **characterized in that** a first frequency of the first oscillating signal (LO_1), a multiple of the first frequency, a second frequency of the second oscillating signal (LO_2) and a multiple of the second frequency are not within the third frequency band (BD_3).

3. The RF receiver device of claim 1, **characterized in that** the first frequency converter (304) comprises:
a first oscillating signal generator, controlled by the controller (312), for generating the first oscillating signal (LO_1); and
a first mixer, coupled to the first filter (302), the first oscillating signal generator and the second filter (306), for mixing the first RF signal(RF_1) with the first oscillating signal (LO_1), to output the second RF signal (RF_2) to the second filter (306).

4. The RF receiver device of claim 3, **characterized in that** the first frequency converter (304) further comprises:
a first phase-locked loop unit, coupled to the first oscillating signal generator, for stabilizing a frequency of the first oscillating signal (LO_1).

5. The RF receiver device of claim 1, **characterized in that** the second frequency converter (308) comprises:
a second oscillating signal generator, controlled by the controller (312), for generating the second oscillating signal (LO_2); and
a second mixer, coupled to the second filter (306), the second oscillating signal generator and the third filter (310), for mixing the second RF signal (RF_2) with the second oscillating signal (LO_2), to output the third RF signal (RF_3) to the third filter (310).

6. The RF receiver device of claim 5, **characterized in that** the second frequency converter (308) further comprises:
a second phase-locked loop unit, coupled to the second oscillating signal generator, for stabilizing a frequency of the second oscillating signal (LO_2).

7. The RF receiver device of claim 1, **characterized in that** the first frequency band (BD_1) substantially ranges between 1.95GHz and 3GHz, the second frequency band (BD_2) substantially ranges between 1.15GHz and 2.2GHz, and the third frequency band (BD_3) substantially ranges between 1.1 GHz and 2.15GHz.

8. The RF receiver device of claim 7, **characterized in that** the frequency of the first oscillating signal (LO_1) substantially equals 4.15GHz and the frequency of the second oscillating signal (LO_2) substantially equals 3.3GHz.
